# EUROPEAN PATENT APPLICATION

(11) **EP 4 310 592 A1**
(43) Date of publication of application: **24.01.2024**
(21) Application number: 23186263.2
(22) Date of filing: 19.07.2023
(51) Int. Cl.: G03F 7/00, G02B 1/02, B24B 13/00

(54) **METHOD OF PRODUCING AN OPTICAL ELEMENT FOR A LITHOGRAPHY APPARATUS**

(30) Priority: 20.07.2022 DE 102022118146
(71) Applicant: Carl Zeiss SMT GmbH, 73447 Oberkochen (DE); Carl Zeiss Jena GmbH, 07745 Jena (DE)
(72) Inventor: WOLKE, Conrad, 73447 Oberkochen (DE); THONAGEL, Volker, 73447 Oberkochen (DE); KLINGHAMMER, Stefan, 73447 Oberkochen (DE); HILD, Kerstin, 73447 Oberkochen (DE); LUNDT, Nils, 73447 Oberkochen (DE)
(74) Representative: Horn Kleimann Waitzhofer Schmid-Dreyer Patent- und Rechtsanwälte PartG mbB

(57) **Abstract**

Method of producing an optical element (200) for a lithography apparatus (100), comprising the steps of:
a) detecting (S2) a height profile (216) of a surface (208) of a crystal substrate (202) of the optical element (200), and
b) ascertaining (S3), using the height profile (216) detected, an installed orientation (δ2, δ4, δ6) of the optical element (200) in an optical system (102, 104) of the lithography apparatus (100) in relation to a stress-induced birefringence on incidence of polarized radiation (204), where the installed orientation (δ2, δ4, δ6) is an orientation in relation to a rotation of the optical element (200) about a centre axis (214) of the optical element (200) that runs through the surface (208).

## Description

The present invention relates to a method of producing an optical element for a lithography apparatus.

The content of the priority application DE 10 2022 118 146.4 is incorporated by reference in its entirety.

Microlithography is used for production of microstructured component parts, for example integrated circuits. The microlithography process is performed with a lithography apparatus, which has an illumination system and a projection system. The image of a mask (reticle) illuminated by means of the illumination system is projected here by means of the projection system onto a substrate, for example a silicon wafer, which is coated with a light-sensitive layer (photoresist) and arranged in the image plane of the projection system, in order to transfer the mask structure to the light-sensitive coating of the substrate.

In order to ensure a sufficient lifetime, optical elements of the lithography apparatus may be produced from a crystal substrate, for example calcium fluoride (CaF₂). Crystals with cubic symmetry such as CaF₂ are optically isotropic without symmetry-breaking disorder. However, the process of crystal growth, for example, can give rise to stresses owing to the material processing or a temperature gradient. These stresses can lead to stress-induced birefringence, for example under mechanical stress. This can affect the polarization properties of radiation transmitted by the optical element in question. This leads to limitation of the resolution of the lithography apparatus.

What is known is that, in the case of radiation propagating in the [111] crystal direction of the crystal lattice of the crystal substrate, distortion of the polarization properties is minimal. Moreover, US 6,904,073 B2, for example, discloses that the distortion of the polarization properties varies on rotation of the optical element about its centre axis ("clocking") and especially has six minima in the angle-of-rotation distribution. By suitable rotary orientation of the optical element, it is thus possible to minimize the influence of stress-induced birefringence in the case of transmitted polarized radiation. However, known methods for ascertaining the optimal rotary orientation are inconvenient and entail a complex test setup.

Against this background, it is an object of the present invention to provide an improved method of producing an optical element for a lithography apparatus.

Accordingly, a method of producing an optical element for a lithography apparatus is proposed. The method comprises the following steps:
a) detecting a height profile of a surface of a crystal substrate of the optical element, and
b) ascertaining, using the height profile detected, an installed orientation of the optical element in an optical system of the lithography apparatus in relation to a stress-induced birefringence on incidence of polarized radiation, where the installed orientation has an orientation in relation to a rotation of the optical element about a centre axis of the optical element that runs through the surface.

In this way, it is possible in a more simple manner to ascertain an optimal installed orientation of the optical element in relation to stress-induced birefringence. In particular, the proposed ascertaining of the optimal installed orientation can be inserted seamlessly and without any great extra difficulty into the conventional method of producing the crystal substrate of an optical element. This replaces a process step required in any case for detecting the height profile (surface fit), such that the information as to the optimal installed orientation, which is of great value to a user of the optical element, is also generated in a simple manner.

The effect of stress-induced birefringence is more particularly that polarization properties of radiation transmitted by the optical element are altered and distorted. For example, radiation passing through the optical element, in the case of stress-induced birefringence, is subject to a loss of contrast owing to a change in polarization direction.

Stress-induced birefringence and the change in the polarization properties of transmitted radiation caused thereby varies on rotation of the optical element about its centre axis ("clocking"). By suitable rotary orientation of the optical element, it is thus possible to minimize the influence of stress-induced birefringence in the case of transmitted polarized radiation.

The installed orientation is especially ascertained with reference to (for example as a function of) the height profile ascertained. The installed orientation thus ascertained is especially an installed orientation in relation to stress-induced birefringence. The installed orientation of the optical element in the optical system that has been ascertained using the height profile detected is especially an orientation for which stress-induced birefringence on incidence of polarized radiation is low and/or minimal, such that distortion of the polarization properties of radiation transmitted by the optical element is low.

The method serves more particularly for production of the crystal substrate of the optical element. The surface of the crystal substrate is especially an end face of the optical element. The surface of the crystal substrate may be a flat face or a curved face.

The height profile of the surface especially describes the surface structure of the crystal substrate. The height profile of the surface can especially be used to derive an installed orientation of the optical element in the optical system of the lithography apparatus that is favourable with regard to stress-induced birefringence.

The detecting of the height profile of the surface includes, for example, detecting a surface fit (of a surface fit image), i.e. detecting a variance in shape of the real surface from an intended surface shape. The height profile is detected, for example, with the aid of an interferometry measurement.

The installed orientation ascertained may have, for example, one or more values of an angle of rotation (azimuthal angle) with regard to rotation about the centre axis.

The centre axis is, for example, a face normal of the surface. The centre axis is, for example, at right angles to a main plane of extent of the optical element.

The centre axis or axis of rotation is, for example, an axis that runs through the centre of mass of the optical element. The centre axis or axis of rotation is, for example, an axis that runs parallel to the surface normal of the outer face of the surface of the crystal substrate that is closest to the centre of mass. The aforementioned properties of the centre axis or axis of rotation, rather than relating to the final geometry of the finished optical element, may also relate to a stage in the preceding process to give the final geometry of the optical element.

The centre axis or axis of rotation is, for example, the sum total, weighted by light intensity, of all normal vectors of the illuminated area of the optical element in its respective position with regard to the incidence of polarized radiation.

The "incidence of polarized radiation" in operation of the optical element in the optical system comprises the incidence of linearly polarized, vertically polarized and/or horizontally polarized radiation onto the optical element. The polarized radiation is, for example, polarized DUV radiation. A direction of propagation/direction of radiation of the radiation toward the optical element in operation of the optical element is, for example, a direction inclined by an angle of incidence relative to the centre axis. The angle of incidence has, for example, a value in the range from 30° to 60° and/or is, for example, 45°. However, the angle of incidence may also have a different value.

The ascertaining of the installed orientation of the optical element using the height profile ascertained comprises, for example, ascertaining, using the height profile ascertained, an installed orientation of the optical element in the optical system for which stress-induced birefringence on incidence of polarized radiation is low and/or minimal compared to other installed orientations in relation to the rotation of the optical element about the centre axis.

In one embodiment, the method comprises the following step that precedes step a):
polishing the surface of the crystal substrate so as to create the height profile of the surface.

In particular, the polishing of the surface creates the height profile of the surface that visualizes a favourable installed orientation in relation to stress-induced birefringence on incidence of polarized radiation. It can also be stated that the polishing of the surface visualizes a structure present in the crystal substrate that is indicative of and/or causes stress-induced birefringence on the surface as a surface structure with the height profile.

The polishing of the surface comprises, for example, polishing of an entire surface on one side (e.g. an end face) of the crystal substrate. However, the polishing of the surface may also comprise, for example, polishing only of a section of a surface on one side (e.g. an end face) of the crystal substrate. This can have the advantage that a further polishing step for removal of the height profile can be dispensed with.

In a further embodiment, the polishing comprises magneto-rheological polishing of the surface.

Magneto-rheological polishing or magneto-rheological finishing (MRF) is performed with a magneto-rheological fluid composed of magnetic particles, polishing media and water. For example, the fluid is applied continuously to a rotating wheel by means of a nozzle. The rotating wheel has, for example beneath its wheel surface, a magnet to generate a magnetic field that alters the viscosity of the fluid. For example, magnetic particles (e.g. iron particles) of the fluid become aligned in the magnetic field and form a rigid structure that adheres to the wheel, and water and abrasive particles become concentrated as a solidified, thin polish layer on the surface.

The crystal substrate, for example, is clamped into a movable holder and immersed into the polishing layer by the surface to be processed. The movable holder may, for example, also include driving means, a control unit and the like for (e.g. (fully) automatic) positioning of the crystal substrate.

In a further embodiment, the polishing of the surface is conducted by sweeping across the surface in a spiral, and the spiral sweeping proceeds from an outer region of the surface in a spiral about a centre of the surface defined by the centre axis toward the centre.

The surface is especially polished by what is called the round method, also called the R-phi method. In particular, the surface is swept at azimuthal angles with decreasing radius, similarly to the way in which a pickup sweeps across a phonographic record.

The applicant has established in experiments that polishing by the round method removes material at the surface such that a surface structure with a height profile is created, from which an installed orientation which is favourable with regard to stress-induced birefringence can be inferred. In other words, it has been found that the polishing of the surface visualizes a structure present in the crystal substrate that is indicative of and/or causes stress-induced birefringence on the surface as a surface structure with the height profile.

The spiral sweeping of the surface can be effected, for example, by moving the crystal substrate and/or by moving a polishing tool/polishing head of a polishing device.

In a further embodiment, the surface is polished by rotating the optical element about the centre axis and simultaneously moving a polishing tool radially toward a centre of the surface defined by the centre axis.

In a further embodiment, the method comprises the following step after step b):
marking the installed orientation ascertained on the optical element.

This allows the installed orientation ascertained to be read off on the optical element itself at a later juncture and/or ascertained by means of a measuring device, for example a commercially available interferometer.

In the marking operation, in particular, a marking is applied to the optical element, for example on the crystal substrate, an outer face of the crystal substrate, the surface of the crystal substrate and/or an edge region of the surface of the crystal substrate.

The marking may be a permanent or non-permanent marking. The marking is, for example, painted on (for example with a pen, marker pen and/or silver marker pen) or engraved on (for example by means of laser engraving and/or sandblasting engraving).

In a further embodiment, the method, after the marking of the installed orientation ascertained on the optical element, comprises a step of polishing the surface to remove the height profile of the surface such that a marking identifying the installed orientation ascertained on the optical element is preserved.

This allows the surface structure introduced in the first polishing step, for example by the round method, to be removed again in a second polishing step. This can achieve lower surface roughness of the surface without losing the marking of the optimal installed orientation.

The second polishing step is effected, for example, by meandering magneto-rheological polishing.

In a further embodiment, the crystal substrate includes a crystal having cubic symmetry, a monocrystal, a fluoride crystal, calcium fluoride, magnesium fluoride, barium fluoride and/or lutetium aluminium garnet.

A crystal having cubic symmetry, for example calcium fluoride (CaF₂),
has high crystal symmetry. A monocrystal (also called single crystal) is a macroscopic crystal, the units of which (atoms, ions or molecules) form a continuously uniform, homogeneous crystal lattice. The empirical formula of magnesium fluoride is MgF₂, that of barium fluoride is BaF₂, and that of lutetium aluminium garnet is LuAG.

In a further embodiment, the surface of the crystal substrate is formed by a [111] crystal plane of the crystal substrate.

In a further embodiment, the surface of the crystal substrate is formed by a [100] crystal plane, a [010] crystal plane or a [001] crystal plane of the crystal substrate.

The nomenclature of the crystal planes [111], [100], [010] and [001] corresponds to the nomenclature of planes in the crystal lattice based on Miller indices a, b, c, which is customary in crystallography.

The surface of the crystal substrate may alternatively be formed by any other plane with regard to the crystal order of the crystal substrate.

In a further embodiment, the optical element comprises a transmitting optical element, a partly transmitting optical element, a beam splitter, a beam splitter of an optical pulse extender, a lens element and/or a chamber window of the lithography apparatus.

An optical pulse extender is also called an optical pulse stretcher. A chamber window of the lithography apparatus is, for example, a chamber window of a gas chamber of a light source of the lithography apparatus.

In a further embodiment, the ascertaining of the installed orientation of the optical element ascertains an angle of rotation of the optical element in relation to the rotation of the optical element about the centre axis for which stress-induced birefringence on incidence of the polarized radiation is low and/or minimal compared to other angles of rotation in relation to the rotation of the optical element about the centre axis.

Also ascertained, for example, are multiple values for angles of rotation of the optical element in relation to the rotation of the optical element about the centre axis for which stress-induced birefringence on incidence of the polarized radiation has a minimum (e.g. a local minimum).

In a further embodiment, the ascertaining of the installed orientation of the optical element ascertains an angle of rotation of the optical element relative to a polarization plane of the incident polarized radiation.

The optimal angle(s) of rotation of the optical element relative to the polarization plane of the incident polarized radiation has/have, for example, values between 0° and 90°.

The polarization plane of the incident polarized radiation, which is electromagnetic radiation, is formed, for example, by a vector of the electrical field of linear-polarized incident radiation.

In a further embodiment, the ascertaining of the installed orientation of the optical element ascertains an angular distribution of height values of the ascertained height profile of the surface, wherein angles of the angular distribution correspond to a respective angle of rotation of the optical element in relation to the rotation of the optical element about the centre axis.

For example, the height profile of the surface is detected by ascertaining a surface fit image, and height values or intensity values corresponding to the height values are integrated and/or averaged within predetermined azimuthal angle ranges (e.g. circle segments of the surface in the case of a circular surface) of the surface fit image.

"A" or "an" in the present case should not necessarily be understood to be restrictive to exactly one element. Instead, a plurality of elements, for example two, three or more, may also be provided. Nor should any other numeral used here be understood to the effect that there is a restriction to exactly the stated number of elements. Instead, unless indicated otherwise, numerical deviations upwards and downwards are possible.

Further possible implementations of the invention also include combinations, not mentioned explicitly, of features or embodiments described above or hereinafter with respect to the exemplary embodiments. In this case, a person skilled in the art will also add individual aspects as improvements or supplementations to the respective basic form of the invention.

Further advantageous configurations and aspects of the invention are the subject of the dependent claims and also of the working examples of the invention that are described hereinafter. The invention is explained in detail hereinafter on the basis of preferred embodiments with reference to the appended figures.
Fig. 1 shows a schematic view of one embodiment of a DUV lithography apparatus;
Fig. 2 shows an optical element of the lithography apparatus from Fig. 1;
Fig. 3 shows the optical element from Fig. 2 in a top view;
Fig. 4 shows the optical element from Fig. 2 in a front view;
Fig. 5 illustrates a [111] plane of a crystal lattice;
Fig. 6 illustrates a [100] plane of a crystal lattice;
Fig. 7 illustrates a [010] plane of a crystal lattice;
Fig. 8 illustrates a [001] plane of a crystal lattice;
Fig. 9 shows a crystal substrate of the optical element from Fig. 2 during a polishing operation on a surface of the optical element;
Fig. 10 shows a view similar to Fig. 9, with illustration of a polishing pattern;
Fig. 11 shows a greyscale image of a height profile of the surface from Fig. 9 after polishing;
Fig. 12 shows an angular distribution of height values of the image in the height profile from Fig. 11; and
Fig. 13 shows a flow diagram for illustration of a method of producing an optical element for a lithography apparatus.

Unless indicated to the contrary, elements that are the same or functionally the same have been given the same reference signs in the figures. It should also be noted that the illustrations in the figures are not necessarily true to scale.

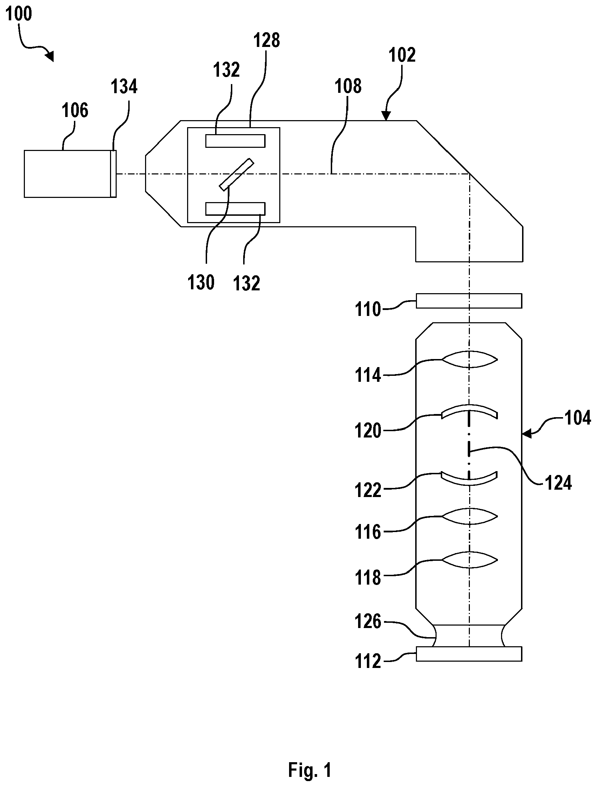

Fig. 1 shows a schematic view of a DUV lithography apparatus 100, which comprises a beam-shaping and illumination system 102 and a projection system 104 (also referred to hereinafter as "projection lens"). In this case, DUV stands for "deep ultraviolet" and denotes a wavelength of the working light of between 30 and 250 nm. The beam-shaping and illumination system 102 and the projection system 104 are preferably each arranged in a vacuum housing (not shown). Each vacuum housing is evacuated with the aid of an evacuation device (not illustrated). The vacuum housings are surrounded by a machine room (not illustrated), in which driving apparatuses for mechanically moving or adjusting optical elements can be provided. Furthermore, electrical controllers and the like may also be arranged in the machine room.

The DUV lithography apparatus 100 has a light source 106. For example, an ArF excimer laser that emits radiation 108 in the DUV range, at for example 193 nm, may be provided as the light source 106. In the beam-shaping and illumination system 102, the radiation 108 is focused and the desired operating wavelength (working light) is filtered out of the radiation 108. The beam-shaping and illumination system 102 may have optical elements (not illustrated), for example mirrors or lens elements.

After passing through the beam-shaping and illumination system 102, the radiation 108 is guided onto a photomask (reticle) 110. The photomask 110 takes the form of a transmissive optical element and may be disposed outside the systems 102, 104. The photomask 110 has a structure which is imaged on a wafer 112 in reduced form by means of the projection system 104.

The projection system 104 has a plurality of lens elements 114, 116, 118 and/or mirrors 120, 122 for projecting an image of the photomask 110 onto the wafer 112. In this case, individual lens elements 114, 116, 118 and/or mirrors 120, 122 of the projection system 104 may be arranged symmetrically relative to an optical axis 124 of the projection system 104. It should be noted that the number of lens elements and mirrors shown here is purely illustrative and is not restricted to the number shown. A greater or lesser number of lens elements 114, 116, 118 and/or mirrors 120, 122 may also be provided.

An air gap between the last lens element (not shown) and the wafer 112 can be replaced by a liquid medium 126 which has a refractive index of >1. The liquid medium 126 can be high-purity water, for example. Such a set-up is also referred to as immersion lithography and has an increased photolithographic resolution. The medium 126 can also be referred to as an immersion liquid.

The ArF excimer laser used by way of example in a DUV lithography apparatus 100, as light source 106, emits radiation in the form of short light pulses of duration about 20 ns. In the case of typical pulse energies of 10 mJ or more, the high power peaks of the laser constitute a considerable degradation risk for downstream optical elements of the beam-shaping and illumination system 102 and of the projection system 104. In order to avoid degradation of downstream optics, it is possible to use an optical pulse extender (optical pulse stretcher, OPuS) 128. The optical pulse stretcher 128 comprises one or more beam dividers 130 (e.g. 45° beam dividers) that outcouple a portion of the radiation 108. The outcoupled portion of the radiation 108 then experiences, with the aid of multiple reflection at highly reflective mirrors (not shown), a time delay with respect to the portion of the radiation 108 transmitted by the beam splitter 130, before following the latter after being reflected again at the beam splitter 130. The highly reflective mirrors are mounted adjustably, for example, on holders 132.

The beam dividers 130 used in the optical pulse stretcher 128 are produced here in particular from a crystal material with cubic symmetry, for example calcium fluoride (CaF₂).

Lens elements for the DUV lithography apparatus 100, for example the lens elements 114, 116, 118, or a chamber window 134 of a gas chamber of the light source 106, may also be produced from a crystal material with cubic symmetry, for example CaF₂.

It is known that optically isotropic crystals, for example as a result of stresses or mechanical stress, can cause stress-induced birefringence of an incident light beam. Birefringence means that the refractive index depends on the polarization direction. It is also possible for cubic crystals such as CaF₂, which are intrinsically optically isotropic, to become birefringent, for example, under mechanical stress (stress-induced birefringence). The causes of such disorder and stress may originate from the process of crystal growth, from the material processing, from mechanical stress, from mechanical contact with a mount, from temperature gradients resulting from inhomogeneous heating in operation and/or as a result of material degradation (possibly in conjunction with the occurrence of sliding planes).

Stress-induced birefringence of the beam splitter 130, of one of the lens elements 114, 116, 118, of the chamber window 134 or of other optical elements of the DUV lithography apparatus 100 can disrupt the polarization properties of the transmitted radiation 108. In particular, different refraction of the two polarization components of the radiation 108 can occur at a surface of the optical element 114, 116, 118, 130, 134 in question, so as to result in different deflections and hence splitting of the polarization components. In addition, on passage through the respective optical element 130, 114, 116, 118, 134, a phase difference may occur between the polarization components of the transmitted radiation. The result is a blurred image, which limits the achievable resolution of the DUV lithography apparatus 100.

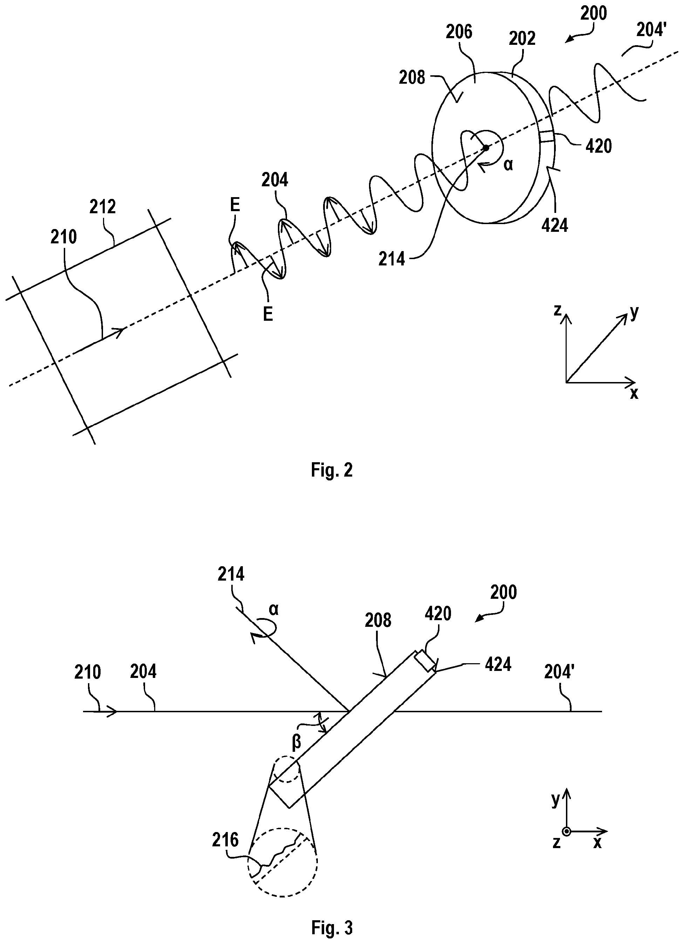

Fig. 2 shows, by way of example, an optical element 200 of the DUV lithography apparatus 100. The optical element 200 is, for example, a beam splitter 130 of the optical pulse stretcher 128. In other examples, however, it may be another optical element (e.g. 114, 116, 118, 134) of the DUV lithography apparatus 100. The optical element 200 has a crystal substrate 202. The crystal substrate 202 comprises, for example, a CaF₂ crystal. In the ready-produced state, the optical element 200 also has coatings and the like, which are not shown in the figures and are not described further hereinafter, since this concerns a process for producing the crystal substrate 202, especially for processing the crystal substrate 202.

The crystal substrate 202 has an end face 206 which has a surface 208 and faces the incident radiation 204. It should be noted that, in the state in which a coating (not shown) has been applied to the end face 206, the surface 208 of the crystal substrate 202 - contrary to the representation in the figures (e.g. Fig. 2) - is not visible.

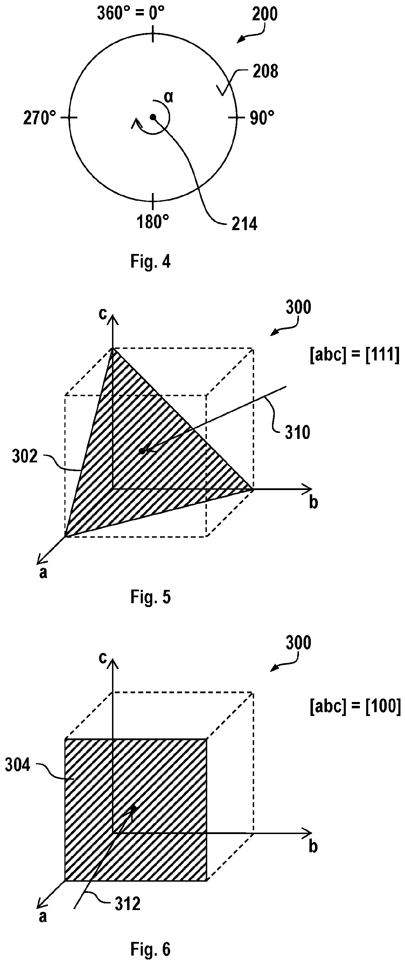

The surface 208 of the crystal substrate 202 may be formed, for example, by a [111] crystal plane 302 (Fig. 5) of the crystal lattice 300 of the crystal substrate 202. Alternatively, the surface 208 of the crystal substrate 202 may also be formed, for example, by a [100] crystal plane 304, [010] crystal plane 306 or [001] crystal plane 308 of the crystal lattice 300 of the crystal substrate 202. In other examples, the surface 208 of the crystal substrate 202 may also be formed by any other plane of the crystal lattice 300 of the crystal substrate 202.

In Figures 5 to 8, these crystal planes 302, 304, 306, 308 of a cubic crystal 300, for example a CaF₂ monocrystal, are identified. The nomenclature of the crystal planes 302, 304, 306, 308 corresponds to the nomenclature of crystal planes in the crystal lattice based on Miller indices a, b, c, which is customary in crystallography. In Figures 5 to 8, the crystal plane 302 is shown by [abc] = [111], the crystal plane 304 by [abc] = [100], crystal plane 306 by [abc] = [010] and the crystal plane 308 by [abc] = [001].

The radiation 204 incident on the optical element 200 as shown in Fig. 2 is, for example, linear-polarized DUV radiation (similarly to the radiation 108 in Fig. 1) with a propagation direction 210. A vector of the electrical field of the radiation 204 is labelled by the reference sign E. The radiation 204 shown in Fig. 2 is vertically polarized in particular. A polarization plane 212 of the radiation 204 is formed by the electrical field vector E and the propagation direction 210. In other examples, the radiation 204 may, for example, also be horizontally polarized. As described in more detail hereinafter, it is possible by suitable rotation of the optical element 200 about a centre axis 214, i.e. by suitable adjustment of an angle of rotation α (azimuthal angle α) of the optical element 200, to minimize disruption of the polarization properties of the radiation 204 on passage through the optical element 200.

Fig. 3 shows the optical element 200 from Fig. 2 in a top view. As can be seen in Fig. 3, the propagation direction 210 of the incident radiation 204 is inclined relative to the surface 208 by an angle β. The angle β is, for example, 45°. The radiation transmitted by the optical element 200 is identified by the reference numeral 204'. If the optical element 200 is a beam splitter, there is also a reflected component of the radiation 204, but this is not shown in the figures for reasons of clarity.

Fig. 4 shows the optical element from Fig. 2 in a front view looking at the surface 208 of the crystal substrate 202 (it is also pointed out here that, in the state in which one or more coatings have been applied to the surface 208 of the crystal substrate 202, the surface 208 - contrary to the representation in the figures - is no longer visible). Fig. 4 once again illustrates the rotation of the optical element 200 about its centre axis 214 for adjustment of the angle α. This adjustment of the angle α is also referred to as "clocking". Additionally shown in Fig. 4 are values of the angle α of 0°, 90°, 180°, 270° and 360°.

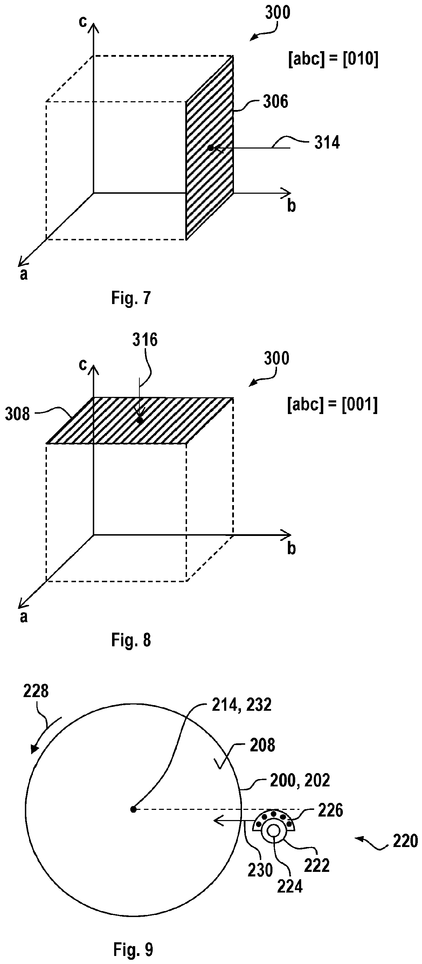

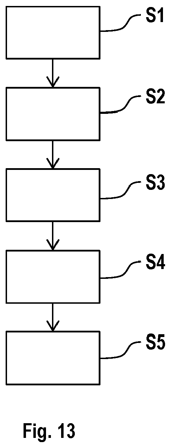

There follows a description of a method of producing an optical element for a lithography apparatus with reference to Figures 9 to 13. For example, the optical element 200 shown in Figures 2 to 4 is produced for the DUV lithography apparatus 100 shown in Fig. 1. In particular, the method ascertains an installed orientation of the optical element 200 in an optical system (for example the beam-shaping and illumination system 102 or the projection system 104 in Fig. 1) which is favourable in relation to stress-induced birefringence.

In a first step S1 of the process, the surface 208 of the crystal substrate 202 of the optical element 200 is polished. The polishing in step S1 is especially effected in such a way that a height profile 216 (see enlarged detail in Fig. 3) of the surface 208 is created, by means of which a structure which is present in the crystal substrate 202 and is indicative of and/or causes stress-induced birefringence becomes visible at the surface 208 as a surface structure with the height profile 216.

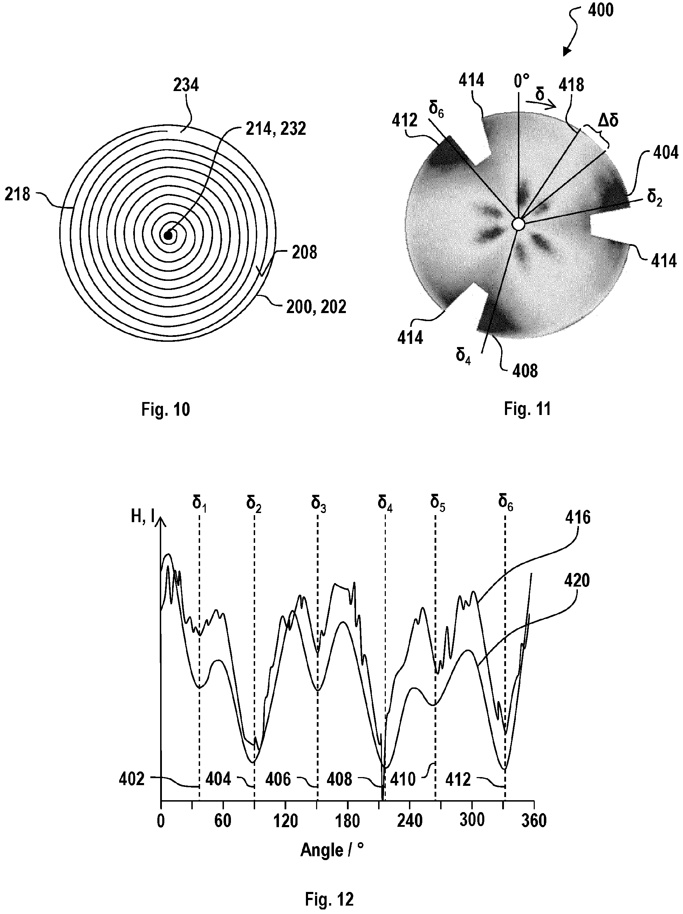

For this purpose, the surface 208 is processed, for example, by a magneto-rheological polishing method using what is called a round method (R-phi method) in which the surface 208 is processed in a spiral pattern 218 (Fig. 10). It can also be stated that the surface 208 is swept in a similar manner to a phonographic record, where a pickup runs in a spiral pattern across the record.

An apparatus 220 (Fig. 9) for magneto-rheological polishing has, for example, a rotating wheel 222 as a tool head with a magnet 224 in its interior. By means of a nozzle (not shown), a magneto-rheological fluid 226 is applied continuously to the rotating wheel 222. The magneto-rheological fluid 226 especially comprises magnetic particles, polishing media and water. The magnetic field generated by the magnet 224 alters the viscosity of the fluid 226. For example, iron particles in the fluid 226 become aligned and form a rigid structure that adheres to the wheel 222, and water and abrasive particles become concentrated as a solidified, thin polish layer on the surface of the wheel 222. The apparatus 220 for magneto-rheological polishing also comprises a holder (not shown) for holding and rotating (arrow 228) of the crystal substrate 202 about its centre axis 214. In addition, the apparatus 220 for magneto-rheological polishing also has a device (not shown) for moving the wheel 222 in a radial direction 230 of the optical element 200.

By rotating the optical element 200 about the centre axis 214 in the direction of movement 228 (Fig. 9) and simultaneously moving the polishing tool 222 radially toward a centre 232 of the surface 208 which is defined by the centre axis 214, the surface 208 is polished. This brings about spiral sweeping (spiral pattern 218 in Fig. 10) of the surface 208 by the polishing head 222. In particular, the surface 208 is processed in a polishing manner from an outer region 234 (Fig. 10) of the surface 208 in a spiral manner toward the centre 232.

The applicant has established in experiments that the described polishing by the round method removes material at the surface 208 such that a surface structure with a height profile 216 (Fig. 3) indicative of stress-induced birefringence is created. In other words, the polishing described elaborates a structure present in the crystal substrate 202 which is associated with stress-induced birefringence as a characteristic height profile 216 of the surface 208. This means consequently that the height profile 216 created by the polishing according to the invention corresponds to a stress-induced birefringence when the optical element 200 is used in an optical system. Accordingly, by evaluating the height profile 216, it is possible to ascertain a favourable and/or optimal installed orientation (especially an optimal azimuthal angle α) of the optical element 200.

In a second step S2 of the method, the height profile 216 of the surface 208 of the crystal substrate 202 that has been created in step S1 is detected.

Fig. 11 shows, by way of example, a detected surface fit image 400 of the surface 208 after polishing in step S1. The surface fit image 400 is detected, for example, by interferometry measurement. In the surface fit image 400 in Fig. 11, the height profile 216 (Fig. 3) of the surface 208 is shown in greyscale after polishing in step S1. Thus, the grey shades in the surface fit image 400 in Fig. 11 correspond to different height values. Since the surface fit image 400 has been ascertained, for example, by an interferometry measurement, the grey shades shown in Fig. 11 can also constitute intensities detected in the interferometry measurement, which in turn correspond to height values of the height profile 216.

The height profile 216 detected by the surface fit image 400 has, for example (e.g. for a CaF₂ crystal substrate), as a function of the azimuthal angle δ, six local minima 402, 404, 406, 408, 410 and 412 (i.e. minima of the height H or intensity I) at average angle values δ of δ1, δ2, δ3, δ4, δ5 and δ6. In Fig. 11, for reasons of clarity, only the three main minima 404, 408 and 412 at average angles δ of δ2, δ4 and δ6 are identified. Fig. 12 shows all six minima 402, 404, 406, 408, 410 and 412. It is pointed out that, for a crystal substrate 202 made of a material other than CaF₂ - for example BaF₂ or LuAG - a height profile 216 detected by a surface fit image 400 may also have different material-characteristic properties.

It is noted that three recesses 414 that can be seen in the surface fit image 400 in Fig. 11 were caused by a holder (not shown). In order to record the surface fit image 400, however, the holder is removed and hence the recesses 414 are of no importance for the evaluation.

In a third step S3 of the process, using the height profile 216 ascertained, i.e., for example, using the surface fit image 400 shown in Fig. 11, a favourable installed orientation of the optical element 200 in an optical system 102, 104 is ascertained. In particular, an installed orientation of the optical element 200 for which stress-induced birefringence on incidence of polarized radiation 204 (Fig. 2) is at a minimum is ascertained. The installed orientation is an orientation in relation to the rotation (azimuthal rotation) of the optical element 200 about its centre axis 214.

In particular, an angle of rotation α (Fig. 2) of the optical element 200 in relation to the rotation about the centre axis 214 for which stress-induced birefringence on incidence of the polarized radiation 204 is at a minimum is ascertained. It is possible here, for example, also to ascertain multiple values for the angle of rotation α for which stress-induced birefringence on incidence of the polarized radiation 204 has a minimum (e.g. a local minimum). In addition, the angle of rotation α may also additionally be ascertained relative to the plane of polarization 212 (Fig. 2) of the incident polarized radiation 204.

As shown in Fig. 12, the installed orientation of the optical element 200 is ascertained by ascertaining an angle distribution 416 of height values H or corresponding intensity values of the detected height profile 216 of the surface 208, i.e., for example, of the surface fit image 400. For this purpose, the height values H or intensity values I are integrated or averaged in predetermined angle ranges Δδ (e.g. circle segments 418, Fig. 11) of the detected surface fit image 400. It should be noted that the angle range Δδ and the corresponding circle segment 418 in Fig. 11, for reasons of illustration, are shown in excessively large size. In addition, the integrated and/or averaged values (e.g. height values H or intensity values I) are plotted as angle distribution 416 over the entire angle range of the full-circle of 360°. Fig. 12 thus shows the six minima at δ1, δ2, δ3, δ4, δ5 and δ6 in the angle distribution 416.

In addition, Fig. 12 shows a graph 420 adapted from the literature that shows the intrinsic birefringence of a [111]-oriented CaF₂ crystal. As the applicant is thus able to demonstrate, a high degree of accordance, especially with regard to the position of the six minima 402, 404, 406, 408, 410 and 412, is apparent between the graph 420 that describes the birefringence and the angle distribution 416 ascertained with the aid of the detected height profile 216, i.e. from the surface fit image 400. The applicant is thus able to present an alternative method of ascertaining the installed orientation of an optical element which is favourable with regard to stress-induced birefringence. In particular, the installed orientation which is favourable with regard to stress-induced birefringence, i.e. the angle of rotation α which is favourable with respect to stress-induced birefringence, can be ascertained directly from the surface fit image 400 of the height profile 216 as one or more of the angles δ1 to δ6 of the minima 402 to 412 (especially δ2, δ4, δ6 of the main minima 404, 408, 412), without an additional test setup and an additional test method. In particular, it is possible to modify a process step of polishing the surface 208 (step S1) and of detecting the height profile 216 (surface fit image 400) which is required in any case such that the information as to the optimal installation angle α is also obtained without any great extra difficulty. An angle δ2, δ4, δ6 of each of the main minima 404, 408, 412 in Fig. 12 can be regarded as a favourable installation angle α (Fig. 2) for the purposes of "clocking" of the optical element 200.

In a fourth step S4 of the method, the favourable installation orientation ascertained, for example one of the angles δ2, δ4, δ6, is marked on the optical element 200. This allows the favourable installed orientation ascertained to be read off on the optical element 200 itself, for example by a customer, and/or ascertained by means of a measuring device, for example a commercially available interferometer.

In step S4, in particular, a marking 424 (Figures 2 and 3) is made on the optical element 200 at one or more of the favourable angles of rotation δ2, δ4, δ6 ascertained in step S3. In the example shown, the marking 424 is painted onto an outer face 422 of the optical element 200 (for example with a marker pen). In other examples, a marking 424 may also be engraved into the optical element 200 and/or made in an edge region of the surface 208.

In an optional fifth step S5 of the method, the surface 208 is polished again. This further polishing step serves to remove the height profile 216 of the surface 208 which is created in step S1. This does not remove the marking 424 applied (Fig. 2) that indicates the installed orientation ascertained. Employing step S5 makes it possible to achieve a lower roughness of the surface 208. At the same time, the marking 424 that shows the user the angle of orientation α with which the optical element 200 should be installed into an optical system (e.g. 102, 104, Fig. 1) in order to minimize stress-induced birefringence is preserved.

Although the present invention has been described with reference to exemplary embodiments, it is modifiable in various ways.

### LIST OF REFERENCE SIGNS

- 100: DUV lithography apparatus
- 102: Beam-shaping and illumination system
- 104: Projection system
- 106: Light source
- 108: Radiation
- 110: Photomask
- 112: Wafer
- 114: Lens element
- 116: Lens element
- 118: Lens element
- 120: Mirror
- 122: Mirror
- 124: Optical axis
- 126: Medium
- 128: Optical pulse extender
- 130: Beam splitter
- 132: Holder
- 134: Chamber window
- 200: Optical element
- 202: Crystal substrate
- 204, 204': Radiation
- 206: End face
- 208: Surface
- 210: Direction of propagation
- 212: Polarization plane
- 214: Centre axis
- 216: Height profile
- 218: Spiral pattern
- 220: Apparatus
- 222: Wheel
- 224: Magnet
- 226: Fluid
- 228: Direction of rotation
- 230: Direction
- 232: Centre
- 234: Region
- 300: Crystal
- 302: Crystal plane
- 304: Crystal plane
- 306: Crystal plane
- 308: Crystal plane
- 310: Crystal axis
- 312: Crystal axis
- 314: Crystal axis
- 316: Crystal axis
- 400: Surface fit image
- 402: Minimum
- 404: Minimum
- 406: Minimum
- 408: Minimum
- 410: Minimum
- 412: Minimum
- 414: Cutout
- 416: Angle distribution
- 418: Circle segment
- 420: Graph
- 422: Lateral surface
- 424: Marking
- α: Angle
- 6: Angle
- δ: Angle
- δ1: Angle
- δ2: Angle
- δ3: Angle
- δ4: Angle
- δ5: Angle
- δ6: Angle
- a: Miller index
- b: Miller index
- c: Miller index
- E: Vector of the electrical field
- H: Height value
- I: Intensity value
- S1-S5: Method steps
- X: Direction
- Y: Direction
- Z: Direction

## Claims

1. Method of producing an optical element (200) for a lithography apparatus (100), comprising the steps of:
a) detecting (S2) a height profile (216) of a surface (208) of a crystal substrate (202) of the optical element (200), and
b) ascertaining (S3), using the height profile (216) detected, an installed orientation (δ2, δ4, δ6) of the optical element (200) in an optical system (102, 104) of the lithography apparatus (100) in relation to a stress-induced birefringence on incidence of polarized radiation (204), where the installed orientation (δ2, δ4, δ6) has an orientation in relation to a rotation of the optical element (200) about a centre axis (214) of the optical element (200) that runs through the surface (208).

2. Method according to Claim 1, wherein the method comprises the following step that precedes step a):
polishing (S1) the surface (208) of the crystal substrate (202) so as to create the height profile (216) of the surface (208).

3. Method according to Claim 2, wherein the polishing (S1) comprises magneto-rheological polishing of the surface (208).

4. Method according to Claim 2 or 3, wherein the polishing (S1) of the surface (208) is conducted by sweeping across the surface (208) in a spiral, and the spiral sweeping proceeds from an outer region (234) of the surface (208) in a spiral (218) about a centre (232) of the surface (208) defined by the centre axis (214) toward the centre (232).

5. Method according to any of Claims 2-4, wherein the surface (208) is polished (S1) by rotating the optical element (200) about the centre axis (214) and simultaneously moving a polishing tool (222) radially toward a centre (232) of the surface (208) defined by the centre axis (214).

6. Method according to any of Claims 1-5, wherein the method includes the following step after step b):
marking (S4) the installed orientation (δ2, δ4, δ6) ascertained on the optical element (200).

7. Method according to Claim 6, wherein the method, after the marking (S4) of the installed orientation (δ2, δ4, δ6) ascertained on the optical element (200), comprises a step of polishing (S5) the surface (208) to remove the height profile (216) of the surface (208) such that a marking (424) identifying the installed orientation (δ2, δ4, δ6) ascertained on the optical element (200) is preserved.

8. Method according to any of Claims 1-7, wherein the crystal substrate (202) includes a crystal (300) having cubic symmetry, a monocrystal, a fluoride crystal, calcium fluoride, magnesium fluoride, barium fluoride and/or lutetium aluminium garnet.

9. Method according to any of Claims 1-8, wherein the surface (208) of the crystal substrate (202) is formed by a [111] crystal plane (302) of the crystal substrate (202).

10. Method according to any of Claims 1-8, wherein the surface (208) of the crystal substrate (202) is formed by a [100] crystal plane (304), a [010] crystal plane (306) or a [001] crystal plane (308) of the crystal substrate (202).

11. Method according to any of Claims 1-10, wherein the optical element (200) comprises a transmitting optical element (130, 114, 116, 118), a partly transmitting optical element (130), a beam splitter (130), a beam splitter (130) of an optical pulse extender (128), a lens element (114, 116, 118) and/or a chamber window (134) of the lithography apparatus (100).

12. Method according to any of Claims 1-11, wherein the ascertaining (S3) of the installed orientation (δ2, δ4, δ6) of the optical element (200) ascertains an angle of rotation (α) of the optical element (200) in relation to the rotation of the optical element (200) about the centre axis (214) for which stress-induced birefringence on incidence of the polarized radiation (204) is lower and/or minimal compared to other angles of rotation in relation to the rotation of the optical element about the centre axis.

13. Method according to any of Claims 1-12, wherein the ascertaining (S3) of the installed orientation (δ2, δ4, δ6) of the optical element (200) ascertains an angle of rotation (α) of the optical element (200) relative to a polarization plane (212) of the incident polarized radiation (204).

14. Method according to any of Claims 1-13, wherein the ascertaining (S3) of the installed orientation (δ2, δ4, δ6) of the optical element (200) ascertains an angular distribution (416) of height values (H) of the ascertained height profile (216) of the surface (208), and wherein angles (δ) of the angular distribution (416) correspond to a respective angle of rotation (α) of the optical element (200) in relation to the rotation of the optical element (200) about the centre axis (214).
